(19) **Europäisches Patentamt**
**European Patent Office**
**Office européen des brevets**

(11) **EP 2 221 895 B1**

(12) **EUROPÄISCHE PATENTSCHRIFT**

(45) Veröffentlichungstag und Bekanntmachung des Hinweises auf die Patenterteilung:
**19.10.2011 Patentblatt 2011/42**

(21) Anmeldenummer: **10154004.5**

(22) Anmeldetag: **18.02.2010**

(51) Int Cl.:
***H01L 39/02*** *(2006.01)*  ***H01R 4/68*** *(2006.01)*

(54) **Verfahren zur Herstellung einer supraleitenden Verbindung von MgB2-Supraleiterdrähten über eine MgB2-Matrix aus einem Mg-infiltrierten Borpulver-Presskörper**

Method for manufacturing a superconductive connection of MgB2 superconductor wires via a MgB2 matrix made of a Mg-infiltrated boron powder press body

Procédé de fabrication d'une connexion supraconductrice de fils supraconducteurs en MgB2 par une matrice en MgB2 faite d'un comprimé en poudre de boron infiltré par du magnésium

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **21.02.2009 DE 102009010112**

(43) Veröffentlichungstag der Anmeldung:
**25.08.2010 Patentblatt 2010/34**

(73) Patentinhaber: **Bruker EAS GmbH**
**63450 Hanau (DE)**

(72) Erfinder:
 • **Tenbrink, Felicitas**
  **63776, Mömbris (DE)**
 • **Aubele, André**
  **63457, Hanau (DE)**
 • **Glücklich, Volker**
  **63546, Hammersbach (DE)**
 • **Sailer, Bernd**
  **63755, Alzenau (DE)**
 • **Schlenga, Klaus**
  **76351, Linkenheim (DE)**

(74) Vertreter: **Kohler Schmid Möbus**
**Patentanwälte**
**Ruppmannstraße 27**
**70565 Stuttgart (DE)**

(56) Entgegenhaltungen:
**GB-A- 2 448 051**

 • LI X H ET AL: "High critical current joint of MgB2 tapes using Mg and B powder mixture as flux" SUPERCONDUCTOR SCIENCE AND TECHNOLOGY, IOP PUBLISHING, TECHNO HOUSE, BRISTOL, GB, Bd. 21, Nr. 2, 1. Februar 2008 (2008-02-01), Seiten 25017/1-25017/5, XP020128600 ISSN: 0953-2048
 • GIUNCHI G ET AL: "The reactive liquid Mg infiltration process to produce large superconducting bulk MgB2 manufacts" CRYOGENICS, ELSEVIER, KIDLINGTON, GB LNKD- DOI:10.1016/J.CRYOGENICS. 2005.11.011, Bd. 46, Nr. 2-3, 1. Februar 2006 (2006-02-01), Seiten 237-242, XP025166672 ISSN: 0011-2275 [gefunden am 2006-02-01]
 • GIUNCHI G ET AL: "Superconducting Joints Between MgB2 Wires and Bulks" IEEE TRANSACTIONS ON APPLIED SUPERCONDUCTIVITY, Bd. 20, Nr. 3, 1. Juni 2010 (2010-06-01), Seiten 1524-1527, XP002594514 IEEE,USA ISSN: 1051-8223 DOI: 10.1109/TASC. 2010.2040260

EP 2 221 895 B1

**Beschreibung**

Die Erfindung betrifft ein Verfahren zur supraleitenden Verbindung von zwei oder mehr Drähten, die jeweils mindestens ein Filament enthaltend $MgB_2$ oder enthaltend eine Mischung von Mg und B aufweisen, wobei die supraleitende Verbindung durch freigelegte Endbereiche der Filamente über eine $MgB_2$-Matrix erfolgt.

Ein solches Verfahren ist aus der US 7,226,894 B2 bekannt geworden.

Supraleiterdrähte, durch die ein elektrischer Strom verlustfrei fließen kann, werden in vielfältiger Weise eingesetzt, insbesondere für Hochfeld-Magnetspulen. Supraleitermaterialien werden dabei erst unterhalb einer materialspezifischen Sprungtemperatur $T_c$ supraleitend, so dass Supraleitermaterialien für den technischen Einsatz gekühlt werden müssen. Eines der im technischen Einsatz wichtigsten Supraleitermaterialien ist NbTi, mit einer Sprungtemperatur von ca. 10 K. Da für diese niedrige Sprungtemperatur eine Kühlung mit kryogenem Helium (Siedepunkt ca. 4 K) erforderlich ist, ist der Einsatz von NbTi relativ teuer.

Im Jahre 2001 wurde Supraleitung im System Mg-B entdeckt, welches mit einer Sprungtemperatur von ca. 39 K für $MgB_2$ eine relativ kostengünstige Kühlung ohne kryogenes Helium zulässt. Dadurch könnten bei technischen Anlagen die Betriebskosten gesenkt und die Wartungsfreundlichkeit erhöht werden. Auch weist $MgB_2$ ein im Vergleich zu NbTi höheres kritisches Magnetfeld Bc2 auf. Daher ist das Supraleitersystem $MgB_2$ derzeit Gegenstand zahlreicher Forschungs- und Entwicklungsaktivitäten.

Die EP 1 390 992 B1 (DE 602 13 588 T2) beschreibt ein Verfahren zur Herstellung von $MgB_2$, wobei eine poröse Vorform aus einem mechanisch aktivierten, kristallinem Borpulver gefertigt wird und die Vorform zusammen mit metallischem Magnesium in einem Behälter unter Inertbedingungen erhitzt wird. Dabei sickert flüssiges Magnesium durch die poröse Vorform und reagiert zu $MgB_2$.

Eine Schwierigkeit im technischen Einsatz des $MgB_2$-Supraleitersystems besteht in der Bereitstellung von supraleitenden Verbindungsstellen ("Joints"), insbesondere zwischen zwei $MgB_2$-Supraleiterdrähten. Die Qualität der supraleitenden Verbindungsstellen begrenzt dabei die Leistungsfähigkeit des gesamten Supraleitersystems.

Aus der US 6,921,865 B2 ist ein Joint von zwei Supraleiterdrähten bekannt geworden, wobei freigelegte NbTi-Filamente der Supraleiterdrähte in eine Pulverschüttung von $MgB_2$ hineinragen und mit dieser verpresst werden.

Aus der US 7,226,894 B2 ist eine Verbindung von zwei $MgB_2$-Supraleiterdrähten bekannt geworden, bei der die $MgB_2$-Filamente an den Enden zweier Supraleiterdrähte freigelegt und in Überlappung gebracht werden. Die freigelegten Enden werden dann zusammen mit einer Mischung aus Borpulver und Magnesiumpulver erhitzt, wobei in einer chemischen Reaktion von Bor und Magnesium $MgB_2$ entsteht. Das entstandene $MgB_2$ dient der supraleitenden Verbindung der beiden Drähte. Das entstandene $MgB_2$ ist jedoch stark porös und die resultierende Stromtragfähigkeit des Joints ist relativ gering.

Die DE 10 2006 020 829 A1 beschreibt eine supraleitfähige Verbindung von Supraleiterdraht-Leiteradern, die beispielsweise aus $MgB_2$ bestehen können. Dabei werden freigelegte Leiterader-Enden in einer Hülse von einer Pulverschüttung von $MgB_2$ angeordnet. Die Pulverschüttung wird anschließend mitsamt der Hülse verpresst.

X. Li et al. beschreiben in Supercond. Sci. Technol. 21 (2008) 025017 (5pp) ein Verfahren zur supraleitenden Verbindung von Drähten, wobei freigelegte Enden von $MgB_2$-Filamenten in Drähten mit Fe-Umhüllung mittels einer Pulvermischung aus Mg und B verbunden werden und die Verbindungsstelle in eine Cu-Folie gewickelt, gepresst und dann bei 700°C gesintert wird. Feste B-Partikel reagieren dabei mit geschmolzenem Mg zu $MgB_2$ und stellen eine supraleitende Verbindung zwischen den Filamenten her.

Aufgabe der Erfindung

Der Erfindung liegt die Aufgabe zugrunde, die Qualität, insbesondere Stromtragfähigkeit und kritische Magnetfeldstärke, einer supraleitenden Verbindung von $MgB_2$-Supraleiterdrähten zu verbessern.

Kurze Beschreibung der Erfindung

Diese Aufgabe wird gelöst durch ein Verfahren der eingangs genannten Art, das dadurch gekennzeichnet ist, dass

a) eine Pulverschüttung von Bor-Pulver bereitgestellt wird, in die die freigelegten Endbereiche der Filamente der Drähte hineinragen,
b) die Pulverschüttung mitsamt der hineinragenden, freigelegten Endbereiche der Filamente zu einem Presskörper verdichtet wird,
c) und der Presskörper-von-der Oberfläche des Presskörpers aus von einer Magnesium-Schmelze infiltriert wird.

Mit dem erfindungsgemäßen Verfahren kann eine sehr dichte Umhüllung von $MgB_2$ um die freigelegten (von ihrer nicht-supraleitenden Hülle befreiten) Endbereiche der Filamente der Drähte mit Magnesiumdiborid ($MgB_2$) hergestellt werden. Die Pulverschüttung von Bor-Pulver wird, bei hineinragenden Endbereichen, verpresst (mechanisch verdichtet). Das Pressen findet dabei an pulverförmigem elementarem Bor statt, welches gut in Pressverfahren zu verarbeiten ist. Eine chemische Reaktion braucht beim Pressen noch nicht statt zu finden. Die freigelegten Endbereiche der Supraleiterdrähte stecken sodann fest im Presskörper.

Anschließend wird der Presskörper durch seine Außenflächen von flüssigem Magnesium (Mg-Schmelze) infiltriert und reagiert zu $MgB_2$. Dabei bleibt die Porosität des Presskörpers erhalten, denn das vom Borpulver eingenommene Volumen entspricht recht genau dem Volumen des aus diesem Borpulver erhaltenen $MgB_2$. Über den Presskörper kann also die gewünschte Endporosität im $MgB_2$-Joint eingestellt werden; insbesondere nimmt die Porosität des Presskörpers durch die Reaktion des von außerhalb des Presskörpers einsickernden Magnesium mit dem Borgerüst des Presskörpers nicht zu (anders als bei der Reaktion eines Gemisches von Magnesiumpulver und Borpulver, bei der das Magnesiumpulver nach der Reaktion zu $MgB_2$ zusätzliche Porosität hinterlässt).

Durch einen hoch verdichteten Presskörper - der durch einfache, herkömmliche Pressverfahren aus der Pulverschüttung des Borpulvers leicht erhalten werden kann - kann somit auch ein hochdichter $MgB_2$-Joint erhalten werden. Ein dichter $MgB_2$-Körper des Joints sorgt für gut ausgeprägte supraleitende Stromleitpfade im Joint und somit eine hohe Stromtragfähigkeit des Joints.

Im Rahmen der Erfindung wird also ein monolithischer $MgB_2$-Körper hergestellt, der in Kontakt zu allen zu verbindenden Drähten (bzw. deren Filamenten) steht und während des Verbindungsprozesses der Drähte erzeugt wird. Der erhaltene $MgB_2$-Körper des Presskörpers überbrückt den Zwischenraum zwischen den freigelegten Endbereichen der Filamente der verschiedenen Drähte.

Die Pulverschüttung des Bor-Pulvers enthält keine nennenswerten Mengen von Mg (Mg-Gehalt unter 5% bzgl. Stoffmenge, bevorzugt unter 1%, besonders bevorzugt magnesiumfrei); typischerweise wird als Pulverschüttung reines Bor-Pulver eingesetzt. Beim Verpressen der Pulverschüttung ist in der Regel keine Temperaturbeaufschlagung notwendig. Als Pressverfahren eignen sich insbesondere uniaxiales Pressen und isostatisches Pressen, insbesondere kaltisostatisches Pressen (CIP).

In Rahmen der Erfindung wird der Presskörper ausreichend lange mit der Mg-Schmelze in Kontakt gelassen, bis er vollständig von flüssigem Magnesium durchdrungen ist ("Sickerzeit"), typischerweise über einige Minuten bis ca. eine Stunde, je nach Temperatur der Schmelze (die die Viskosität beeinflusst), Presskörpergeometrie (die die Länge der Sickerpfade beeinflusst) und der Porosität des Presskörpers (die das Benetzungsverhalten mit beeinflusst).

Mit der Infiltration beginnt eine chemische Reaktion von B mit Mg zu $MgB_2$. Die Schmelze-Temperatur beträgt dabei in der Regel 650-750°C. Typischerweise wird der Presskörper über die Mg-Schmelze solange beheizt, bis das gesamte Bor des Presskörpers zu $MgB_2$ durchreagiert ist ("Reaktionszeit"); es ist aber auch möglich, für das vollständige Durchreagieren nach dem Einsickern der Magnesiumschmelze einen zusätzlichen, separaten Temperierungsschritt vorzusehen.

Die Porosität des erhaltenen $MgB_2$-Gerüsts am Joint kann-außerdem mit Mg-Metall aufgefüllt werden, was die Stabilität des Joints verbessert.

Die Filamente der Drähte können $MgB_2$ enthalten oder noch unreagiertes Mg und B. Im Falle von Mg und B enthaltenden Filamenten werden diese nach der Jointfertigung noch durch Temperaturbehandlung zu $MgB_2$ reagiert.

Insgesamt stellt die Erfindung ein einfaches, im industriellen Alltag technisch problemlos umzusetzendes und kostengünstiges Verfahren zur Fertigung qualitativ hochwertiger Joints für die Verbindung von $MgB_2$-Supraleiterdrähten zur Verfügung.

Bevorzugte Varianten der Erfindung

Bevorzugt ist eine Variante des erfindungsgemäßen Verfahrens, wobei das Bor des Bor-Pulvers der Pulverschüttung in amorpher Modifikation vorliegt. Mit amorphem Bor läuft die Reaktion von B und flüssigem Mg zu $MgB_2$ besonders zügig und effizient ab.

Bei einer besonders bevorzugten Verfahrensvariante gilt für die Stoffmengen $n(Mg)$ von Magnesium in der Magnesium-Schmelze und $n(B)$ von Bor im Presskörper $n(Mg)/n(B) \geq 0,5$. Mit anderen Worten, es wird Magnesium im stöchiometrisch erforderlichen Verhältnis oder (bevorzugt) im Überschuss eingesetzt. Dadurch kann eine vollständige Reaktion des Borgerüsts sichergestellt werden. Bei Verwendung von Magnesium in ausreichendem Überschuss kann zusätzlich die ursprüngliche Porosität des Presskörpers mit Mg-Metall erfüllt werden.

Eine Verfahrensvariante sieht vor, dass in Schritt c) der Presskörper in die Mg-Schmelze eingetaucht wird, wobei die Mg-Schmelze in einem Tiegel vorgelegt ist. Ein Tauchverfahren ist besonders einfach auszuführen.

Eine alternative Verfahrensvariante sieht vor, dass der Presskörper für Schritt c) in einem Tiegel angeordnet wird, und anschließend der Tiegel mit der Mg-Schmelze befüllt wird. Die Befüllung des Tiegels mit Mg-Schmelze kann dabei durch ein Ausgießen von flüssiger Mg-Schmelze in den Tiegel, oder auch durch ein Aufschmelzen von festem Mg im Tiegel, bei Anwesenheit des Presskörpers im Tiegel erfolgen. Letzteres kann besonders sicher durchgeführt werden, insbesondere mit bei hohen Temperaturen stets verschlossenem Tiegel. Ein im Tiegel vorgelegtes, festes Magnesium kann beispielsweise in Stangenform oder als Granulat ausgebildet sein.

Bei einer vorteilhaften Weiterentwicklung ist vorgesehen, dass der Tiegel oder eine Beschichtung des Tiegels aus einem gegenüber flüssigem Magnesium inerten Material gefertigt ist, insbesondere wobei dieses Material Nb, Ta, V, Ti oder Fe umfasst. Der inerte Tiegel beugt Verunreinigungen des $MgB_2$ vor und trägt so zu einer hohen Stromtragfähigkeit des gebildeten $MgB_2$ bei. Der Tiegel wird typischerweise für die Sickerzeit oder die Reaktionszeit beheizt, etwa elektrisch.

Bevorzugt ist eine Verfahrensvariante, bei der in Schritt c) der Presskörper vollständig von Mg-Schmelze umgeben ist. Dadurch kann eine gleichmäßige und von allen Seiten erfolgende Durchdringung des Presskörpers der Bor-Pulverschüttung mit Mg-Schmelze erzielt werden.

Eine bevorzugte Verfahrensvariante ist dadurch gekennzeichnet, dass der Presskörper zumindest teilweise von festem Mg umhüllt wird, und dass in Schritt c) der umhüllte Presskörper über die Schmelztemperatur von Magnesium erhitzt wird. Durch die Umhüllung kann auch bei wenig Einsatz von Mg-Material eine gleichmäßige, insbesondere von mehreren Seiten erfolgende Durchdringung des Presskörpers mit Mg-Schmelze erzielt werden. Die Schmelztemperatur von Mg, auf die in Schritt c) erhitzt werden-muss, beträgt ca. 648,8°C; man beachte, dass bei Zusatzbestandteilen im Magnesium sich die Schmelztemperatur verändern (insbesondere absinken) kann. Die Umhüllung kann etwa mit Mg-Folie, Mg-Blechen oder Außenbeschichtungen erfolgen und ist bevorzugt als eine vollständige (allseitige) Umhüllung ausgebildet. Das Aufschmelzen der Umhüllung sollte in einem Tiegel (der bevorzugt inert gegenüber flüssigem Magnesium, und typischerweise beheizt ist) erfolgen; der Wärmeeintrag in die Umhüllung kann insbesondere über Wärmestrahlung erfolgen.

Bei einer besonders bevorzugten Verfahrensvariante erfolgt in Schritt b) eine Verdichtung des Presskörpers auf wenigstens 40%, bevorzugt wenigstens 50%, der theoretischen Dichte. Mit anderen Worten, die Porosität beträgt weniger als 60%, bevorzugt weniger als 50%. Dadurch kann besonders dichtes $MgB_2$-Material im Joint und damit eine besonders hohe Stromtragfähigkeit erreicht werden. Besonders bevorzugt wird eine Verdichtung des Presskörpers auf wenigstens 55% der theoretischen Dichte vorgenommen. Erfindungsgemäß wird jedoch eine Restporosität im Presskörper belassen, die für eine zügige, drucklose Infiltration des gesamten Presskörpers mit Magnesiumschmelze ausreichend ist.

Vorteilhafter Weise erfolgt Schritt c) unter einer reduzierenden oder inerten Atmosphäre, insbesondere unter Argon-Atmosphäre. Dadurch wird eine Verunreinigung (etwa mit Sauerstoff aufgrund von chemischen Reaktionen) des $MgB_2$ verhindert.

Eine bevorzugte Verfahrensvariante sieht vor, dass die freigelegten Endbereiche der Filamente der verschiedenen Drähte aneinander liegend, insbesondere miteinander verflochten, in der Pulverschüttung angeordnet werden. Dadurch wird die Gefahr von schlecht leitenden Übergängen zwischen den Filamenten der verschiedenen Drähte vermindert, und der Zwischenraum zwischen Filamenten verschiedener Drähte wird gering gehalten. Mit Verdrillungen kann das Aneinanderliegen der Drähte auf einfache Weise sichergestellt werden. Die Verdrillung erfolgt am einfachsten solange die Filamente noch metallische Plastizität aufweisen (also vor einer Umwandlung in $MgB_2$).

Besonders bevorzugt ist eine Verfahrensvariante, bei der die D50-Korngröße des Bor-Pulvers ≤ 1 μm beträgt. Dadurch kann ein besonders dichtes $MgB_2$-Material am Joint erhalten werden.

In den Rahmen der vorliegenden Erfindung fällt auch ein supraleitender Joint von zwei oder mehr Drähten, die jeweils mindestens ein Filament enthaltend $MgB_2$ aufweisen, hergestellt mit einem erfindungsgemäßen Verfahren. Der erfindungsgemäße Joint erreicht eine verbesserte Stromtragfähigkeit.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert. Es zeigen:

Fig.1      eine schematische Darstellung von Drähten, die mit dem erfindungsgemäßen Verfahren supraleitend verbunden werden sollen;

Fig. 2      eine schematische Darstellung von Drähten, die mit dem erfindungsgemäßen Verfahren supraleitend verbunden werden sollen, mit verdrillten Filamenten;

Fig. 3a, 3b      eine Presseinrichtung zum erfindungsgemäßen Verdichten einer Bor-Pulverschüttung mit hineinragenden, freigelegten Filamenten von zwei Drähten, vor dem Verdichten (Fig. 3a) und nach dem Verdichten (Fig. 3b), in schematischer Querschnittsdarstellung;

Fig. 4      eine schematische Darstellung eines Tiegels mit Mg-Schmelze, in die ein Presskörper zum erfindungsgemäßen Infiltrieren mit Mg- Schmelze vollständig eingetaucht ist;

Fig. 5      eine schematische Darstellung eines Tiegels mit Mg-Schmelze, in die ein Presskörper zum erfindungsgemäßen Infiltrieren mit Mg- Schmelze teilweise eingetaucht ist;

Fig. 6      eine schematische Darstellung eines Tiegels, in den ein Presskörper mit fester Magnesium-Beschichtung hineinragt, zum Erhitzen und dadurch erfindungsgemäßen Infiltrieren mit Mg- Schmelze.

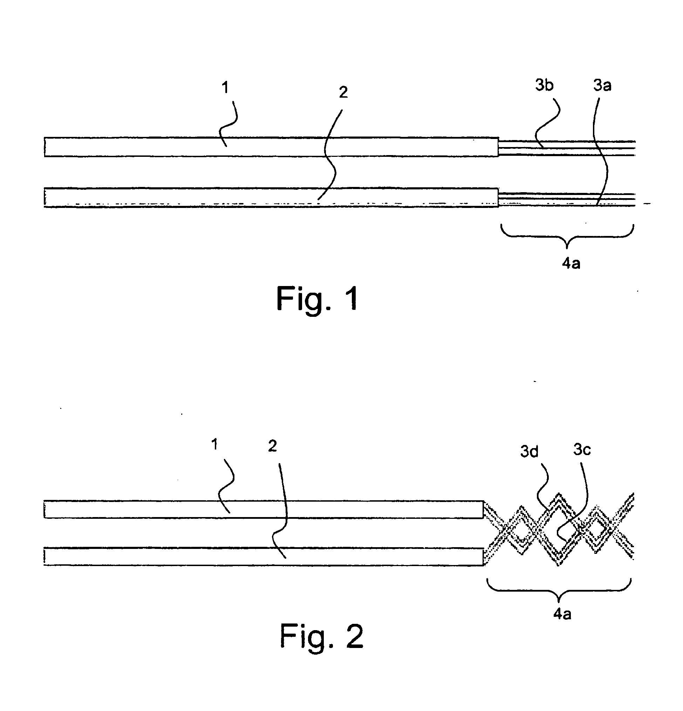

Die **Figur 1** zeigt zwei Supraleiterdrähte 1, 2, die jeweils mehrere Filamente 3a, 3b enthaltend $MgB_2$ umfassen. Man beachte, dass im Rahmen der Erfindung abhängig von der Drahtfertigungstechnik und Applikationssystem sowohl endprozessierte Drähte (enthaltend $MgB_2$-Filamente, Prinzip "react and wind" zum fertigen Einsatz in Anwendungssystemen) oder auch teilprozessierte Drähte (enthaltend Filamente mit unreagiertem oder teilreagiertem Mg und B, Prinzip "wind and react") zum Einsatz kommen können.

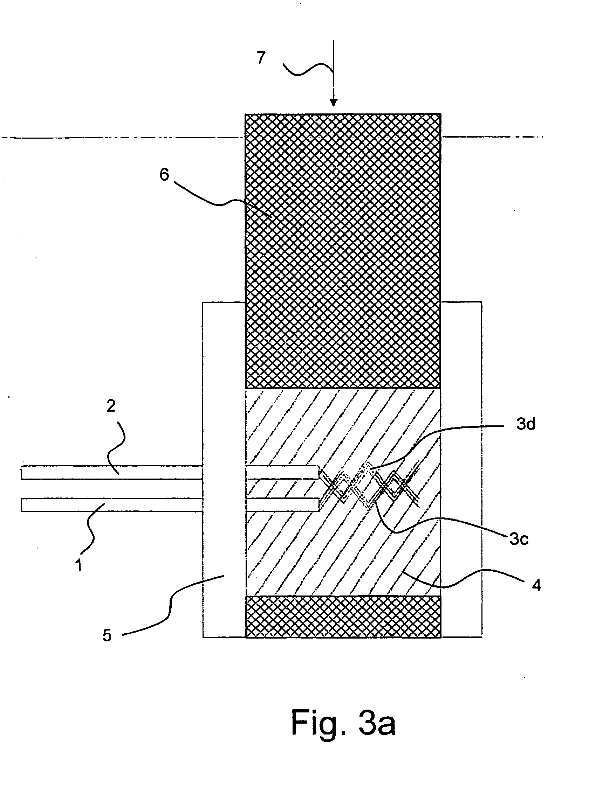

Die Filamente 3a, 3b sind jeweils in einem Endbereich 4a (in Fig. 1 rechtsseitig) freigelegt. Bei den dargestellten Drähten 1, 2 ist dazu im Endbereich 4a eine Ummantelung aus Monel, Edelstahl, Fe, Ni, Nb, Ta, Ti, Cu oder Cu-Legierung entfernt worden, etwa mittels abätzen (Das Freilegen kann auch über andere chemische und/oder mechanische Verfahren erfolgen, etwa Abschleifen oder Anschleifen; es müssen dabei nicht zwingend alle Ummantelungen entfernt werden). Die Filamente 3a, 3b der beiden Drähte 1, 2 sollen mittels der Erfindung supraleitend verbunden werden, vgl. Figuren 3a bis 6. Dafür sollten die Filamente 3a, 3b der verschiedenen Drähte 1, 2 in unmittelbare Nähe zueinander gebracht werden.

**Figur 2** zeigt ähnlich wie Figur 1 zwei Supraleiterdrähte 1, 2, die ebenfalls jeweils mehrere, in einem Endbereich 4a freigelegte Filamente 3c, 3d aufweisen und mittels der Erfindung supraleitend verbunden werden sollen, vgl. Figuren 3a bis 6. Um die elektrische Leitung zwischen den Drähten 1, 2 im zu fertigenden Joint zu verbessern, wurden hier vorbereitend die Filamente 3c, 3d der beiden Drähte miteinander verdrillt.

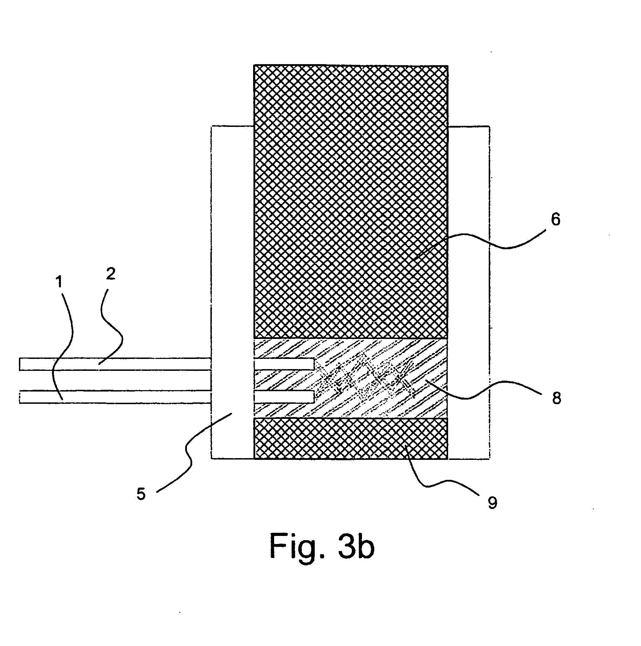

Die Figuren 3a und 3b illustrieren die erfindungsgemäße Fertigung eines Borpulver-Presskörpers zwischen und um die Enden der zwei Drähte 1, 2. Wie in **Figur 3a** dargestellt, sind die freigelegten Endbereiche der Filamente 3c, 3d der Drähte 1, 2 verdrillt und ragen in eine Pulverschüttung 4 hinein. Die Pulverschüttung füllt insbesondere Zwischenräume zwischen den freigelegten Filamenten 3c, 3d der verschiedenen Drähte 1, 2 auf. Die Pulverschüttung 4 besteht im Wesentlichen aus feinkörnigem Bor-Pulver; ggf. sind weiterhin Hilfsstoffe (etwa Wachse oder Öle zur Verbesserung des Pressverhaltens oder Bindemittel für eine verbesserte Festigkeit des Grünkörpers) enthalten, jedoch ist kein metallisches Magnesium in der Pulverschüttung 4 enthalten. Die Pulverschüttung 4 ist in einer Pressform 5 vorgelegt, die eine Durchführung für die beiden Drähte 1, 2 in ihrer seitlichen Wandung aufweist.

Durch Absenken eines Pressstempels 6 in Pfeilrichtung 7 auf die Pulverschüttung 4 kann die Pulverschüttung 4 mechanisch verdichtet werden. Zum Absenken des Pressstempels 6 wird typischerweise eine Kraft bereitstellende Hydraulik oder Mechanik eingesetzt. Der Pressvorgang erfolgt im ausgeführten Beispiel ohne Temperaturbeaufschlagung und benötigt auch keine Schutzgasbedingungen.

**Figur 3b** zeigt den Presskörper (auch genannt Grünkörper) 8 nach der Verdichtung der Pulverschüttung. Der Pressstempel 6 ist weitestgehend in die Pressform 5 eingefahren. Nach Entfernen des Pressstempels 6 (und meist auch des Pressenformbodens 9) kann der Presskörper 8 leicht entnommen werden.

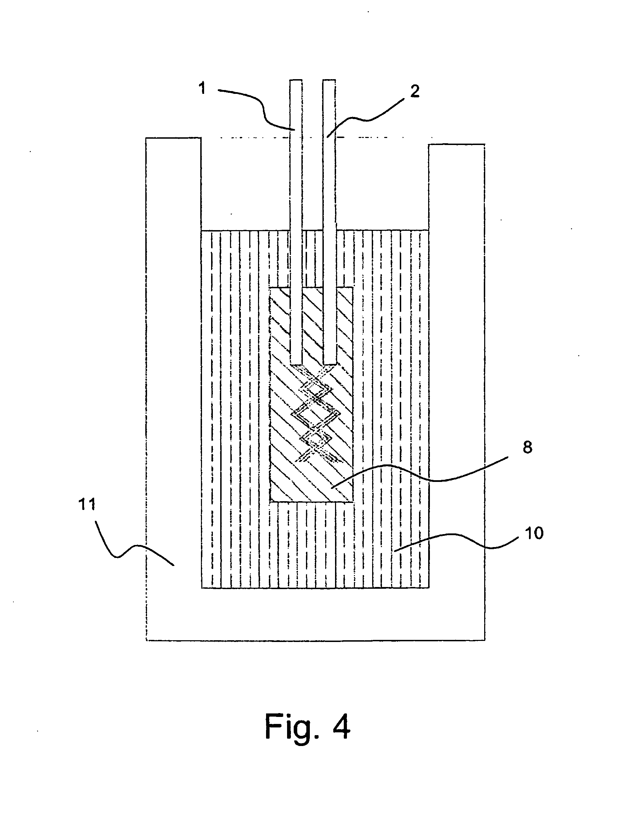

**Figur 4** illustriert eine bevorzugte Art der Infiltration des Presskörpers 8 mit einer Magnesiumschmelze 10. In einem Tiegel 11, der aus einem gegenüber flüssigem Magnesium, Bor und Mg-B-Verbindungen inerten Material wie Niob, Tantal, Vanadium, Titan oder Eisen gefertigt ist, ist unter Schutzgas Magnesiumschmelze 10 eingefüllt. Der Tiegel 11 ist beheizt, um die Mg-Schmelze 10 im flüssigen Aggregatzustand zu halten. Der Presskörper 8 ist vollständig in die Mg-Schmelze 10 eingetaucht, so dass von allen Seiten flüssiges Magnesium in den Presskörper 8 einsickern kann. Das Einsickern erfolgt dabei in eine Restporosität des Presskörpers 8. Restporositäten von typischen Pressverfahren sind in der Regel ausreichend, um eine ausreichende Infiltration zu gewährleisten.

Das eingesickerte flüssige Mg reagiert mit dem Bor-Grundgerüst des Presskörpers 8 zu $MgB_2$, wobei das Volumen des Grundgerüsts erhalten bleibt. Der Presskörper 8 wird ausreichend lange in der Magnesiumschmelze 10 belassen, so dass sowohl eine vollständige Durchdringung mit Magnesiumschmelze 10 als auch eine vollständige Reaktion des Bors zu $MgB_2$ erfolgen kann. Danach wird der durchreagierte Presskörper 8 aus der Mg-Schmelze 10 herausgezogen. In den Poren des nunmehr im Wesentlichen aus $MgB_2$ bestehenden Presskörpers 8 erstarrt dabei verbliebenes Magnesium.

Der durchreagierte Presskörper 8 kann als leistungsfähiger, supraleitender Joint für die beiden Drähte 1, 2 eingesetzt werden.

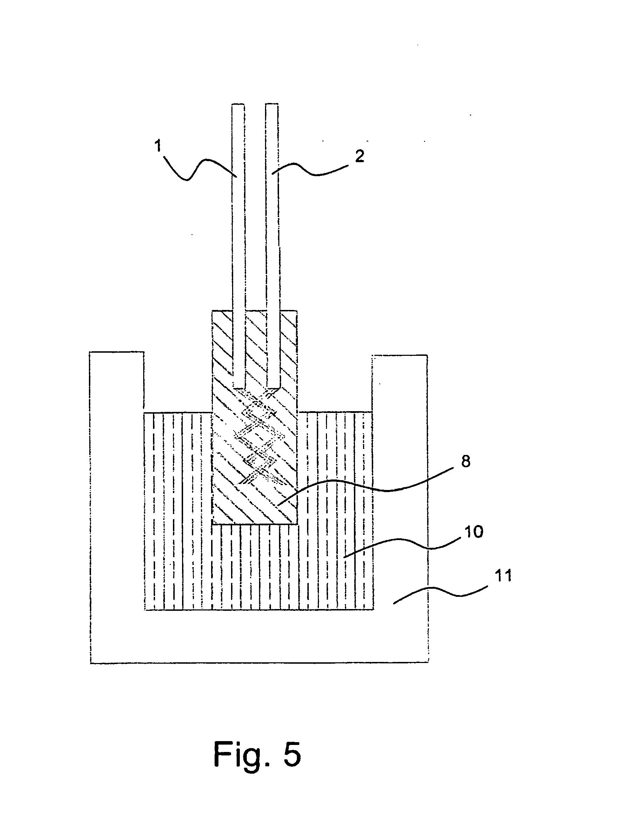

**Figur 5** zeigt eine weitere Möglichkeit der Infiltration des Presskörpers 8 mit Magnesiumschmelze 10 im Rahmen der Erfindung. Der Presskörper 8 taucht dabei nur teilweise in die Magnesiumschmelze 10 im Tiegel 11 ein. Der Presskörper 8 kann dabei über die Drähte 1, 2 hängend gelagert sein (siehe Fig. 5), oder auch auf dem Tiegelboden aufsitzen (nicht gezeigt). Die Magnesiumschmelze 10 kann auch dadurch bereit gestellt werden, dass festes Mg (etwa in Stangenform) im Tiegel 11 zusammen mit dem Presskörper 8 erhitzt wird.

Durch Kapillarkräfte sickert die Magnesiumschmelze 10 auch in die Regionen des Presskörpers 8, die nicht von Magnesiumschmelze 10 außen unmittelbar umgeben sind.

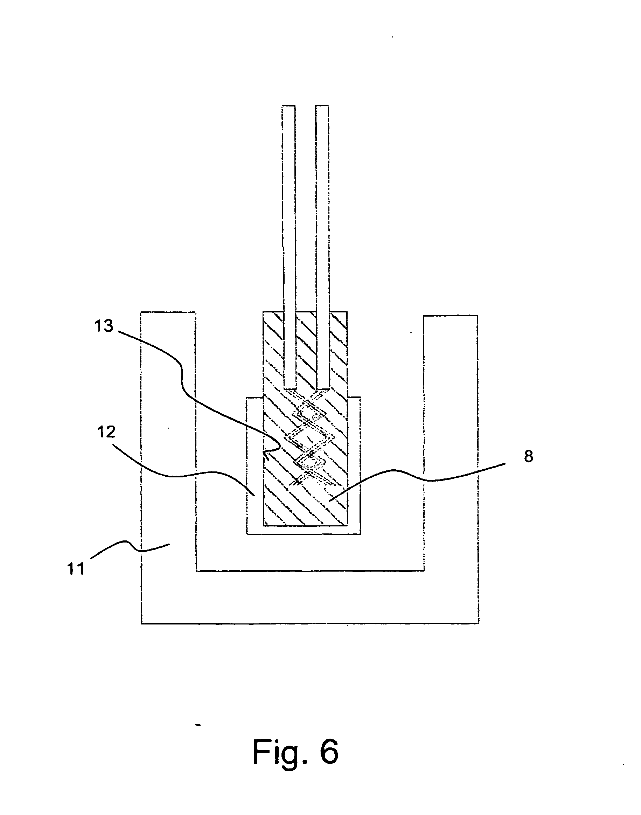

**Figur 6** schließlich illustriert noch eine weitere Möglichkeit der Infiltration des Presskörpers 8 von außen durch Magnesiumschmelze. Der Presskörper 8 ist dabei teilweise von einer Umhüllung 12 aus festem Magnesium, hier einem Mg-Blech, umgeben. Alternativ kann die Umhüllung 12 beispielsweise auch aus Mg-Folie oder einem Magnesiummetall-Formteil bestehen.

Die Gesamtheit von Umhüllung 12 und Presskörper 8 wird über die Schmelztemperatur des Magnesiummaterials der Umhüllung 12 erhitzt. Sodann dringt Magnesiumschmelze durch die Oberfläche (Außenflächen) 13 des Presskörpers 8 in den Presskörper 8 ein und kann zu $MgB_2$ reagieren.

Zur Sicherheit ist die Gesamtheit von Presskörper 8 und Umhüllung 12 von einem Tiegel 11 umgeben, insbesondere um abtropfendes flüssiges Magnesium aufzufangen.

Die Gesamtheit von Umhüllung 12 und Presskörper 8 kann dabei auch im Tiegel 11 aufliegen (nicht dargestellt), um einen besseren Wärmeeintrag vom üblicherweise beheizten Tiegel in die Umhüllung 12 und in den Presskörper 8 zu erhalten.

Man beachte, dass ein Tiegel 11 (vgl. Figuren 4, 5, 6) auch eine geschlossene Hülse um den Presskörper 8 ausbilden kann oder auch eine andere, an die Geometrie des Joints angepasste Form besitzen kann.

**Patentansprüche**

1. Verfahren zur supraleitenden Verbindung von zwei oder mehr Drähten (1, 2), die jeweils mindestens ein Filament (3a-3d) aufweisen, welches $MgB_2$ oder eine Mischung von Mg und B enthält, wobei die supraleitende Verbindung durch freigelegte Endbereiche (4a) der Filamente (3a-3d) über eine $MgB_2$-Matrix erfolgt, **dadurch gekennzeichnet, dass**

    a) eine Pulverschüttung (4) von Bor-Pulver bereitgestellt wird, in die die freigelegten Endbereiche (4a) der Filamente (3a-3d) der Drähte (1, 2) hineinragen, wobei das Bor des Bor-Pulvers der Pulverschüttung (4) in amorpher Modifikation vorliegt,
    b) die Pulverschüttung (4) mitsamt der hineinragenden, freigelegten Endbereiche (4a) der Filamente (3a, 3b) zu einem Presskörper (8) verdichtet wird,
    c) und der Presskörper (8) von der Oberfläche (13) des Presskörpers (8) aus von einer Magnesium-Schmelze (10) infiltriert wird.

2. Verfahren nach Anspruch 1, **dadurch gekennzeichnet, dass** Stoffmengen n(Mg) von Magnesium in der Magnesium-Schmelze und n(B) von Bor im Presskörper (8) eingesetzt werden, für die gilt:

$$n(Mg)/n(B) \geq 0{,}5.$$

3. Verfahren nach Anspruch 2, **dadurch gekennzeichnet, dass** die Porosität des erhaltenen $MgB_2$-Gerüsts des Presskörpers (8) mit MagnesiumMetall aufgefüllt wird.

4. Verfahren nach einem der Ansprüche 1 bis 3, **dadurch gekennzeichnet, dass** in Schritt c) der Presskörper (8) in die Mg-Schmelze (10) eingetaucht wird, wobei die Mg-Schmelze (10) in einem Tiegel (11) vorgelegt wird.

5. Verfahren nach einem der Ansprüche 1 bis 3, **dadurch gekennzeichnet, dass** der Presskörper (8) für Schritt c) in einem Tiegel (11) angeordnet wird, und anschließend der Tiegel (11) mit der Mg-Schmelze (10) befüllt wird.

6. Verfahren nach Anspruch 4 oder 5, **dadurch gekennzeichnet, dass** als Tiegel (11) ein Tiegel gewählt wird, der aus einem gegenüber flüssigem Magnesium inerten Material gefertigt ist, insbesondere wobei dieses Material Nb, Ta, V, Ti oder Fe umfasst.

7. Verfahren nach Anspruch 4 oder 5, **dadurch gekennzeichnet, dass** als Tiegel (11) ein Tiegel gewählt wird, der eine Beschichtung hat, die aus einem gegenüber flüssigem Magnesium inerten Material gefertigt ist, insbesondere wobei dieses Material Nb, Ta, V, Ti oder Fe umfasst.

8. Verfahren nach einem der vorhergehenden Ansprüche, **dadurch gekennzeichnet, dass** in Schritt c) der Presskörper (8) vollständig von Mg-Schmelze (10) umgeben ist.

9. Verfahren nach einem der vorhergehenden Ansprüche, **dadurch gekennzeichnet, dass** der Presskörper (8) zumindest teilweise von festem Mg umhüllt wird, und dass in Schritt c) der umhüllte Presskörper (8) über die Schmelztemperatur von Magnesium erhitzt wird.

10. Verfahren nach einem der vorhergehenden Ansprüche, **dadurch gekennzeichnet, dass** in Schritt b) eine Verdichtung des Presskörpers (8) auf wenigstens 40%, bevorzugt wenigstens 50%, der theoretischen Dichte erfolgt.

11. Verfahren nach einem der vorhergehenden Ansprüche, **dadurch gekennzeichnet, dass** Schritt c) unter einer reduzierenden oder inerten Atmosphäre erfolgt, insbesondere unter Argon-Atmosphäre.

12. Verfahren nach einem der vorhergehenden Ansprüche, **dadurch gekennzeichnet, dass** die freigelegten Endbereiche (4a) der Filamente (3a-3d) der verschiedenen Drähte (1, 2) aneinander liegend, insbesondere miteinander verflochten, in der Pulverschüttung (4) angeordnet werden.

13. Verfahren nach einem der vorhergehenden Ansprüche, **dadurch gekennzeichnet, dass** ein Bor-Pulver eingesetzt wird, dessen D50-Korngröße ≤ 1 μm beträgt.

## Claims

1. Method for superconductingly connecting two or more wires (1, 2), each comprising at least one filament (3a-3d) that contains $MgB_2$ or a mixture of Mg and B, wherein the superconducting connection is realized through exposed end regions (4a) of the filaments (3a-3d) via an $MgB_2$ matrix, **characterized in that**

   a) a bulk powder (4) of boron powder is provided, into which the exposed end regions (4a) of the filaments (3a-3d) of the wires (1, 2) project, wherein the boron of the boron powder of the bulk powder (4) is present in the form of an amorphous modification,
   b) the bulk powder (4) is compacted together with the projecting exposed end regions (4a) of the filaments (3a, 3b) to form a compressed element (8),
   c) and the compressed element (8) is infiltrated from the surface (13) of the compressed element (8) with molten magnesium (10).

2. Method according to claim 1, **characterized in that** the following applies for the amounts of substances n(Mg) of magnesium in the molten magnesium and n(B) of boron in the compressed element (8):

$$n(Mg)/n(B) \geq 0.5.$$

3. Method according to claim 2, **characterized in that** the porosity of the obtained $MgB_2$ frame of the compressed element (8) is filled up with Mg metal.

4. Method according to any one of the claims 1 through 3, **characterized in that** in step c) the compressed element (8) is immersed into the molten Mg (10), wherein the molten Mg (10) is provided in a pot (11).

5. Method according to any one of the claims 1 through 3, **characterized in that** the compressed element (8) is arranged in a pot (11) for step c) and the pot (11) is subsequently filled with molten Mg (10).

6. Method according to claim 4 or 5, **characterized in that** a pot is selected as the pot (11), which is produced from a material that is inert with respect to liquid Mg, in particular, wherein this material comprises Nb, Ta, V, Ti or Fe.

7. Method according to claim 4 or 5, **characterized in that** a pot is selected as the pot (11), which has a coating produced from a material that is inert with respect to liquid Mg, in particular, wherein this material comprises Nb, Ta, V, Ti or Fe.

8. Method according to any one of the preceding claims, **characterized in that** the compressed element (8) is completely surrounded by molten Mg (10) in step c).

9. Method according to any one of the preceding claims, **characterized in that** the compressed element (8) is at least partially encased with solid Mg, and **in that** in step c), the encased compressed element (8) is heated beyond the melting temperature of magnesium.

10. Method according to any one of the preceding claims, **characterized in that** in step b) the compressed element (8) is compacted to at least 40%, preferably at least 50%, of the theoretical density.

11. Method according to any one of the preceding claims, **characterized in that** step c) is performed in a reducing or inert atmosphere, in particular in an argon atmosphere.

12. Method according to any one of the preceding claims, **characterized in that** the exposed end regions (4a) of the filaments (3a-3d) of the different wires (1, 2) are disposed in the bulk powder (4) in such a fashion that they adjoin each other, in particular, are interwoven with each other.

13. Method according to any one of the preceding claims, **characterized in that** a boron powder is used, which has a D50 grain size of ≤1μm.

## Revendications

1. Procédé pour la connexion supraconductrice de deux fils (1, 2) ou plus qui présentent chacun au moins un filament (3a-3d), lequel contient au moins du $MgB_2$ ou un mélange de Mg et B, la connexion supraconductrice étant réalisée par des zones terminales découvertes (4a) des filaments (3a-3d) via une matrice $MgB_2$, **caractérisé en ce que**

   a) une charge pulvérulente (4) de poudre de bore est mise à disposition, dans laquelle s'enfoncent les zones terminales découvertes (4a) des filaments (3a-3d) des fils (1, 2), le bore de la poudre de bore de la charge pulvérulente (4) étant présent en modification amorphe,

b) la charge pulvérulente (4) avec les zones terminales découvertes (4a) des filaments (3a, 3b) qui y sont enfoncées est comprimée en un corps comprimé (8),

c) et le corps comprimé (8) est infiltré par un bain de magnésium en fusion (10) depuis la surface (13) du corps comprimé (8).

2. Procédé selon la revendication 1, **caractérisé en ce que** des quantités de matière n(Mg) de magnésium sont introduites dans le bain de magnésium en fusion et n(B) de bore dans le corps comprimé (8), pour lesquelles s'applique :

$$n(Mg)/n(B) \geq 0,5.$$

3. Procédé selon la revendication 2, **caractérisé en ce que** la porosité du squelette de $MgB_2$ obtenue du corps comprimé (8) est remplie de magnésium métal.

4. Procédé selon une des revendications 1 à 3, **caractérisé en ce qu'**à l'étape c) le corps comprimé (8) est plongé dans le bain de Mg en fusion (10), le bain de Mg en fusion (10) étant présenté dans un creuset (11).

5. Procédé selon une des revendications 1 à 3, **caractérisé en ce que** le corps comprimé (8) est disposé dans un creuset (11) pour l'étape c), et ensuite le creuset (11) est rempli du bain de Mg en fusion (10).

6. Procédé selon la revendication 4 ou 5, **caractérisé en ce que** l'on choisit comme creuset (11) un creuset qui est réalisé à partir d'un matériau inerte vis-à-vis du magnésium liquide, ce matériau comprenant en particulier Nb, Ta, V, Ti ou Fe.

7. Procédé selon la revendication 4 ou 5, **caractérisé en ce que** l'on choisit comme creuset (11) un creuset qui présente un revêtement réalisé dans un matériau inerte vis-à-vis du magnésium liquide, ce matériau comprenant en particulier Nb, Ta, V, Ti ou Fe.

8. Procédé selon une des revendications précédentes, **caractérisé en ce qu'**à l'étape c), le corps comprimé (8) est complètement entouré par le bain de Mg en fusion (10).

9. Procédé selon une des revendications précédentes, **caractérisé en ce que** le corps comprimé (8) est enveloppé au moins partiellement de Mg solide, et qu'à l'étape c) le corps comprimé (8) enveloppé est chauffé par la température de fusion du magnésium.

10. Procédé selon une des revendications précédentes, **caractérisé en ce qu'**à l'étape c), il est réalisé une compression du corps comprimé (8) à au moins 40 %, de préférence au moins 50 %, de la densité théorique.

11. Procédé selon une des revendications précédentes, **caractérisé en ce que** l'étape c) a lieu sous une atmosphère réductrice ou inerte, en particulier sous une atmosphère d'argon.

12. Procédé selon une des revendications précédentes, **caractérisé en ce que** les zones terminales découvertes (4a) des filaments (3a-3d) des différents fils (1, 2) sont disposées l'une à côté de l'autre, en particulier entrelacées, dans la charge pulvérulente (4).

13. Procédé selon une des revendications précédentes, **caractérisé en ce que** l'on utilise une poudre de bore dont la granulométrie D50 est $\leq 1\ \mu m$.

Fig. 1

Fig. 2

Fig. 3a

Fig. 3b

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7226894 B2
- EP 1390992 B1
- DE 60213588 T2

- US 6921865 B2
- DE 102006020829 A1

**In der Beschreibung aufgeführte Nicht-Patentliteratur**

- **X. Li et al.** *Supercond. Sci. Technol.,* 2008, vol. 21, 025017